# EUROPEAN PATENT SPECIFICATION

(11) **EP 2 722 126 B1**
(45) Date of publication and mention of the grant of the patent: **06.01.2016**
(21) Application number: 12800868.7
(22) Date of filing: 11.05.2012
(51) Int. Cl.: B23K 20/12, C23C 14/06

(54) **COATED ROTATING TOOL**
BESCHICHTETES ROTIERENDES WERKZEUG
OUTIL ROTATIF REVÊTU

(30) Priority: 16.06.2011 JP 2011134254
(43) Date of publication of application: 23.04.2014
(73) Proprietor: Sumitomo Electric Industries, Ltd., Chuo-ku Osaka-shi Osaka 541-0041 (JP)
(72) Inventor: MORIGUCHI, Hideki, Itami-shi Hyogo 664-0016 (JP); UTSUMI, Yoshiharu, Itami-shi Hyogo 664-0016 (JP)
(74) Representative: Grünecker Patent- und Rechtsanwälte PartG mbB
(86) International application number: PCT/JP2012/062132
(87) International publication number: WO 2012/172895

(56) References cited:
- WO-A1-2010/074165
- JP-A- 2004 195 525
- JP-A- 2005 199 281
- JP-A- 2008 155 277
- JP-A- 2009 241 085
- JP-A- 2010 264 479
- JP-A- 2010 520 810
- JP-A- 2011 011 235
- JP-A- 2011 504 808

## Description

### TECHNICAL FIELD

The present invention relates to a tool for friction stir welding.

### BACKGROUND ART

In 1991, a friction stir welding technique of joining metal materials such as aluminum alloys was established in the United Kingdom. This technique is for joining metal materials by pressing a cylindrical tool for friction stir welding having a small-diameter protrusion at a tip thereof against joint surfaces of the metal materials to be joined and rotating the tool for friction stir welding, generating frictional heat, and softening and plastically flowing the metal materials at a joint portion by the frictional heat.

"Joint portion" herein refers to a joint interface portion where joining of metal materials by butting the metal materials or placing one metal material on top of the other metal material is desired. Near this joint interface, the metal materials are softened, plastic flow occurs, and the metal materials are stirred. As a result, the joint interface disappears and joining is performed. Furthermore, dynamic recrystallization occurs at the metal materials at the same time. Due to this dynamic recrystallization, the metal materials near the joint interface become fine particles and the metal materials can be joined with high strength (Japanese Patent Laying-Open No. 2003-326372 (PTD 1)).

When aluminum alloys are used as the above-mentioned metal materials, plastic flow occurs at a relatively low temperature of approximately 500°C. Therefore, even when the tool for friction stir welding made of inexpensive tool steel is used, little wear and tear occurs and frequent replacement of the tool for friction stir welding is unnecessary. Therefore, in the friction stir welding technique, the cost required to join the aluminum alloys is low. Thus, in place of a resistance welding method for melting and joining aluminum alloys, the friction stir welding technique has already been in practical use in various applications as a technique of joining components of a railroad vehicle, a vehicle or an aircraft.

At present, the friction stir welding technique is mainly applied to nonferrous metals such as an aluminum alloy or a magnesium alloy in which plastic flow occurs at a relatively low temperature. This friction stir welding technique is superior to the resistance welding method in terms of cost and time required for joining, strength of the joint portion, and the like. Therefore, there is a need for applying the friction stir welding technique to not only joining of the materials in which plastic flow occurs at a low temperature, but also joining of copper alloys or steel materials in which plastic flow occurs at a high temperature of 1000°C or higher.

However, when the friction stir welding technique is applied to the steel materials, the tool for friction stir welding itself is exposed to a high temperature during joining. As a result, the tool for friction stir welding is plastically deformed, and a portion of the tool for friction stir welding that is in contact with the materials to be joined is easily oxidized and becomes worn, which leads to remarkably short tool life.

As an attempt to solve the above-mentioned problem, Japanese Patent Laying-Open No. 2003-326372 (PTD 1), for example, discloses a tool for friction stir welding, in which a portion of a surface of the tool for friction stir welding that is in contact with materials to be joined is coated with a diamond film, thereby increasing the surface hardness, suppressing welding, to the tool for friction stir welding, of low-melting-point light alloy component such as an Al alloy or a Mg alloy serving as the materials to be joined, and lengthening the tool life. According to the tool for friction stir welding as disclosed in Japanese Patent Laying-Open No. 2003-326372 (PTD 1), the wear resistance of the surface thereof can be enhanced and the tool life can be lengthened.

However, the diamond film has a very high thermal conductivity. Therefore, a part of frictional heat generated due to rotation of the tool for friction stir welding escapes to the tool for friction stir welding side, and sufficient conduction of the frictional heat to the materials to be joined side becomes difficult. As a result, an enormous time is required from when a small-diameter protrusion of the tool for friction stir welding is pressed against the materials to be joined to when plastic flow occurs.

In the case of joining of the materials in which plastic flow occurs at a high temperature, the tool for friction stir welding must be rotated at a high speed in order to speed up temperature rise of the materials to be joined. Therefore, if it takes time before plastic flow of the materials to be joined occurs, it is impossible to enjoy such an advantage of the friction stir welding technique that cost and time required for joining can be reduced. As an attempt to solve the above-mentioned problem, Japanese National Patent Publication No. 2003-532542 (PTD 2) discloses a technique of providing a heat flow barrier such that heat is not conducted to a shaft portion of a tool for friction stir welding. Provision of the heat flow barrier as mentioned above allows frictional heat to concentrate on materials to be joined.

As another attempt to suppress deterioration of the surface of the tool for friction stir welding, Japanese Patent Laying-Open No. 2005-152909 (PTD 3) discloses a tool for friction stir welding, including an underlying layer provided on a base material, and an anti-adhesion coating made of TiN, TiAIN or the like and provided on the underlying layer. According to this tool for friction stir welding, adhesion of a metal component (aluminum) in materials to be joined can be prevented in spite of long-term use, and thus, stable processing can be continued.

JP 2011011235 A shows a friction stir welding tool comprising a base material and a coating which can have compressive residual stress.

### CITATION LIST

### PATENT DOCUMENT

PTD 1: Japanese Patent Laying-Open No. 2003-326372
PTD 2: Japanese National Patent Publication No. 2003-532542
PTD 3: Japanese Patent Laying-Open No. 2005-152909

### SUMMARY OF INVENTION

### TECHNICAL PROBLEM

However, when the tool for friction stir welding as described in Japanese Patent Laying-Open No. 2005-152909 (PTD 3) is applied to processing of a difficult-to-join material such as steel having a melting point of 1000°C or higher, the surface of the tool for friction stir welding is exposed to a high temperature of 1000°C or higher, the generated frictional heat is thermally conducted to the base material and the base material is plastically deformed easily. Therefore, sufficiently-long tool life cannot be obtained.

In particular, the anti-adhesion coating in Japanese Patent Laying-Open No. 2005-152909 (PTD 3) has a high thermal permeability. Therefore, the frictional heat generated due to rotation with respect to the materials to be joined is thermally conducted to the base material, and the frictional heat cannot be sufficiently transmitted to the materials to be joined. Thus, it takes time before the temperature of the materials to be joined rises and plastic flow occurs.

The present invention has been made in view of the above-mentioned circumstances, and an object of the present invention is to provide a tool for friction stir welding, which is capable of speeding up temperature rise of the materials to be joined during joining and causing plastic flow of the materials to be joined in a short time to achieve efficient friction stir welding, allows excellent joining at a low rotation speed, and is excellent in oxidation resistance and wear resistance.

### SOLUTION TO PROBLEM

A tool for friction stir welding according to the present invention is a tool for friction stir welding including a base material and a coating layer formed on the base material, wherein the coating layer is formed of two or more layers, and the coating layer as a whole has a thermal permeability of 8000 J/s^{0.5}•m²•K or less, at least one layer of the coating layer includes a hexagonal crystal system and/or an amorphous structure, at least one layer of the coating layer includes a cubic crystal system, and the coating layer has compressive stress.

Preferably, the coating layer is formed of 10 or more layers, and more preferably, is formed of 100 or more layers. Preferably, the coating layer has a thickness of 10 µm or more.

Preferably, the tool for friction stir welding has a chuck portion inserted into a holder, and the coating layer is formed at least on the chuck portion on the base material.

Preferably, the coating layer is formed at least on a portion of the base material that comes into contact with materials to be joined during joining processing. Preferably, at least one layer of the coating layer is formed by a physical vapor deposition method.

The present invention is directed to a method for joining materials to be joined using the tool for friction stir welding, wherein the joining is performed on the materials to be joined having a melting point of 1000°C or higher.

The above-mentioned tool for friction stir welding according to the present invention can be suitably used to join the materials to be joined that are made of a high-melting-point material.

### ADVANTAGEOUS EFFECTS OF INVENTION

Since the tool for friction stir welding according to the present invention has the above-mentioned configuration, the tool for friction stir welding according to the present invention produces such effects that temperature rise of the materials to be joined is promoted during joining to achieve friction stir welding in a short time, the coating layer has excellent heat insulating property, and excellent oxidation resistance and wear resistance are achieved. The tool for friction stir welding having the above-mentioned configuration is simple and inexpensive as compared with the structure in PTD 2 including the heat flow barrier made of a different type of material. In addition, in the tool for friction stir welding, the temperature of the base material does not rise easily, joining in a short time is possible, and excellent wear resistance can be achieved.

### BRIEF DESCRIPTION OF DRAWINGS

Fig. 1 is a schematic cross-sectional view showing one example of a tool for friction stir welding according to the present invention.
Fig. 2 is a schematic cross-sectional view showing another example of the tool for friction stir welding according to the present invention.

### DESCRIPTION OF EMBODIMENTS

The present invention will be described in more detail hereinafter.

### <Tool for Friction Stir Welding>

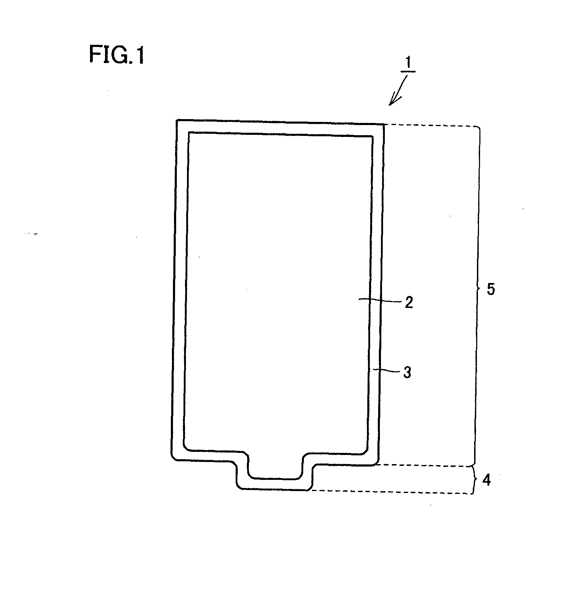

Fig. 1 is a schematic cross-sectional view of a tool for friction stir welding according to the present invention. As shown in Fig. 1, a tool 1 for friction stir welding according to the present invention includes a base material 2 and a coating layer 3 formed on base material 2. Tool 1 for friction stir welding according to the present invention having the above-mentioned configuration can be used very usefully in a friction stir welding (FSW) application, a friction spot joining (spot FSW) application and the like, for example. Tool 1 for friction stir welding according to the present invention is shaped to include a probe portion 4 having a small diameter (a diameter of 2 mm or more and 8 mm or less) and a cylindrical portion 5 having a large diameter (a diameter of 4 mm or more and 20 mm or less). When this is used for joining, probe portion 4 is rotated, with probe portion 4 inserted into or pressed against a joint portion of materials to be joined, and thereby the materials to be joined are joined. In this case, in the friction stir welding application, probe portion 4 is pressed against or inserted into two materials to be joined that are stacked or butted in a line contact manner, and rotating probe portion 4 is moved linearly with respect to the stacked or butted portion, and thereby the materials to be joined are joined. On the other hand, in the friction spot joining application, rotating probe portion 4 is pressed against a desired joint spot of two materials to be joined that are vertically stacked or butted, and rotation of probe portion 4 is continued at this location, and thereby the materials to be joined are joined.

The present invention also relates to a method for joining materials to be joined using the tool for friction stir welding, wherein joining can be performed on the materials to be joined having a melting point of 1000°C or higher. Using the tool for friction stir welding according to the present invention, joining can also be performed on the materials to be joined having a melting point of 1000°C or higher, which has been considered to be difficult conventionally. Therefore, the tool for friction stir welding according to the present invention has very excellent industrial applicability.

As mentioned above, tool 1 for friction stir welding according to the present invention can be used in various applications, and particularly, can be suitably used for joining of high-tensile steel, for which the resistance welding method has been mainly used conventionally. In other words, in the above-mentioned joining of high-tensile steel, tool 1 for friction stir welding according to the present invention provides an alternative to the conventional resistance welding method. In friction stir welding, the materials to be joined are joined in a solid-phase state and dynamic recrystallization occurs at the joint portion, and thus, the structure becomes fine. As a result, the strength of the joint portion is increased as compared with the conventional resistance welding method in which the materials to be joined change into a liquid phase during joining. Therefore, the tool for friction stir welding according to the present invention can be very effectively used for joining of high-tensile steel having high specific strength, and in particular, joining of ultrahigh-tensile steel of 980 MPa or more.

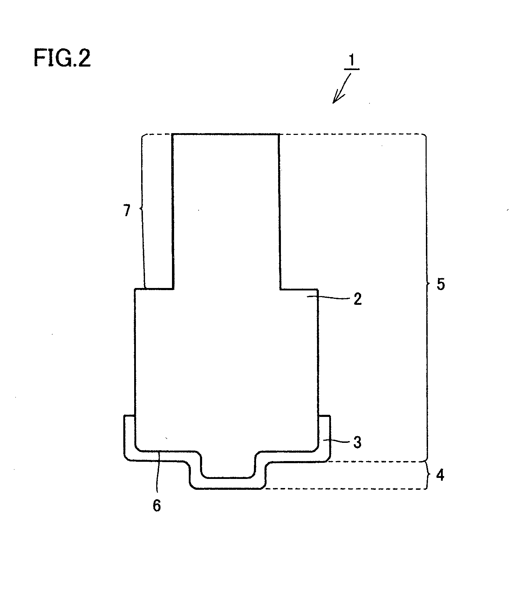

Fig. 2 is a schematic cross-sectional view of a preferable embodiment of the tool for friction stir welding according to the present invention. As shown in Fig. 2, tool 1 for friction stir welding according to the present invention preferably has a chuck portion 7 such that cylindrical portion 5 is inserted into a holder. This chuck portion 7 can be formed by cutting away a part of a side surface of cylindrical portion 5, for example. On the other hand, a portion that comes into contact with the materials to be joined during joining processing is referred to as a shoulder portion 6.

As shown in Fig. 2, coating layer 3 is more preferably formed at least on a portion of base material 2 that comes into contact with the materials to be joined during joining processing. Since coating layer 3 is formed on the portion that comes into contact with the materials to be joined as mentioned above, heat generated due to friction is not easily conducted to the base material. As a result, plastic deformation of base material 2 and shortening of the tool life can be prevented.

Tool 1 for friction stir welding according to the present invention preferably includes base material 2, and coating layer 3 on all or a part of chuck portion 7 on base material 2. Since coating layer 3 is formed on a surface of chuck portion 7 on base material 2 as mentioned above, heat of tool 1 for friction stir welding whose temperature has risen due to conduction of frictional heat can be conducted to the materials to be joined, without escaping to the holder with which tool 1 for friction stir welding is in contact. Since the generated frictional heat is effectively used as mentioned above, friction stir welding of the materials to be joined in a short time or at a low rotation speed is possible. Since the generated frictional heat is effectively used as mentioned above, the life of tool 1 for friction stir welding can be improved.

### <Base Material>

A material that has been conventionally known as above-mentioned base material 2 for joining processing can be used without particular limitation as base material 2 of the tool for friction stir welding according to the present invention. Examples of above-mentioned base material 2 can include, for example, cemented carbide (e.g., WC-based cemented carbide, a material containing Co in addition to WC, or a material to which carbonitride or the like of Ti, Ta, Nb or the like is further added), cermet (mainly composed of TiC, TiN, TiCN or the like), high-speed steel, tool steel, ceramics (such as titanium carbide, silicon carbide, silicon nitride, aluminum nitride, aluminum oxide, sialon, and a mixture thereof), sintered cubic boron nitride, sintered diamond, a hard material having cBN particles dispersed therein, and the like. Particularly when the base material includes nitride or carbonitride of Ti, excellent oxidation resistance can be expected. Therefore, the above-mentioned base material is very preferable for the tool for friction stir welding exposed to high-temperature oxidation environment.

When the cemented carbide is used as base material 2, the effects of the present invention are achieved even if the cemented carbide includes free carbon or an abnormal phase called η phase in the structure thereof.

Base material 2 used in the present invention may be a base material having a modified surface. For example, in the case of the cemented carbide, a β-free layer may be formed on a surface thereof. In the case of the cermet, a surface-hardened layer may be formed. The effects of the present invention are achieved even if the surface is modified as mentioned above.

### <Coating Layer>

In the tool for friction stir welding according to the present invention, coating layer 3 formed on base material 2 is formed of two or more layers, and coating layer 3 as a whole has a thermal permeability of 8000 J/s^{0.5}•m²•K or less. Since coating layer 3 having the above-mentioned thermal permeability is formed, the frictional heat generated due to rotation of the tool for friction stir welding is not easily conducted to the base material side and is easily conducted to the materials to be joined. As a result, temperature rise of the materials to be joined is promoted, and plastic flow of the materials to be joined can be speeded up. More preferably, coating layer 3 as mentioned above has a thermal permeability of 6000 J/s^{0.5}•m²•K or less, and further preferably 5500 J/s^{0.5}•m²•K or less. It is to be noted that in the present invention, a value calculated by means of a thermophysical properties microscope (product name: Thermal Microscope TM3 (BETHEL Co.)) in accordance with a thermoreflectance method is employed as the thermal permeability of coating layer 3. Since coating layer 3 in the present invention as a whole has a heat shield property such that the frictional heat does not easily permeate the base material, the effects of the present invention are achieved. It is essential that the coating layer in the present invention as a whole has a thermal permeability of 8000 J/s^{0.5}•m²•K or less, and one layer forming the coating layer does not necessarily have a thermal permeability of 8000 J/s^{0.5}•m²•K or less.

Coating layer 3 formed on base material 2 of tool 1 for friction stir welding according to the present invention includes two or more layers. In other words, this coating layer 3 is formed of two or more layers having different compositions.

In the present invention, at least one layer of coating layer 3 is characterized by including a hexagonal crystal system and/or an amorphous structure. Since the hexagonal crystal system or the amorphous structure is included as mentioned above, the frictional heat generated due to rotation is not easily conducted to the base material 2 side and is easily conducted to the materials to be joined. As a result, temperature rise of the materials to be joined can be promoted. Thus, plastic flow of the materials to be joined can be speeded up and the joining speed can be further increased. Moreover, by including one or more layers including the hexagonal crystal system or the amorphous structure, the welding resistance to steel is enhanced and the wear resistance can be enhanced.

At least one layer of coating layer 3 is characterized by including a cubic crystal system. The layer including the cubic crystal system exhibits the property of high hardness. Therefore, by including one or more layers including the cubic crystal system, the wear resistance can be enhanced. This layer including the cubic crystal system includes the case of including the hexagonal crystal system and/or the amorphous structure. In other words, the layer including the cubic crystal system may be formed, in some cases, of mixed crystals of the cubic crystal system and the hexagonal crystal system and/or the amorphous structure. In this case, the layer including the cubic crystal system serves also as the layer including the hexagonal crystal system and/or the amorphous structure. The crystal structure of the above-mentioned coating layer can be checked by a diffraction peak of XRD (X-ray diffraction).

Above-mentioned coating layer 3 is provided to give the above-mentioned property. In addition to this property, coating layer 3 can give an effect of enhancing various properties of tool 1 for friction stir welding such as wear resistance, oxidation resistance, toughness, and coloring property for identifying a used probe.

Preferably, the coating layer is formed by a compound which is nitride or oxide of Al and of at least one or more elements selected from the group consisting of Ti, Si, Zr, Hf, Nb, Ta, Mo, Cr, and W, or a solid solution of the compound. According to the conventional knowledge, when a layer made of AlTiN was formed, it was preferable to set an atomic ratio of Al at 50 to 65%. When the atomic ratio of Al exceeded 65%, the hexagonal crystal was precipitated, which led to decrease in hardness of the coating layer and decrease in wear resistance.

In order to deal with the above-mentioned conventional knowledge, the inventors of the present invention found a new fact that overturns the conventional technical common knowledge. Specifically, according to the conventional knowledge, when AlTiN was formed, the atomic ratio of Al was adjusted to be 65% or less in order to avoid formation of the hexagonal crystal in the coating layer. However, according to the research by the inventors of the present invention, it was found that even when the hexagonal crystal is formed in a part of the coating layer, the effect of enhancing the wear resistance is obtained because the thermal permeability of the entire coating layer decreases. In other words, it became clear that, contrary to the conventional art, it is preferable to form the hexagonal crystal structure in at least a part of the coating layer in order to enhance the wear resistance. It also became clear that when Al is contained in combination with Ti, for example, it is preferable to form the hexagonal crystal structure in the coating layer, with the atomic ratio of Al being set at 65% or more. By allowing both the cubic crystal and the hexagonal crystal to be present in one layer, the effect of enhancing the wear resistance can be obtained. In addition, by stacking a layer formed of the hexagonal crystal and a layer formed of the cubic crystal, the effect of enhancing the wear resistance can also be obtained.

The inventors of the present invention studied the atomic ratio of A1 to a combined metal. As a result of their study, it became clear that the hexagonal crystal is easily precipitated in the coating layer and the wear resistance is significantly enhanced, for example, by setting the atomic ratio of Al at 70% or more when Al is combined with V, by setting the atomic ratio of Al at 75% or more when Al is combined with Cr, by setting the atomic ratio of Al at 55% or more when Al is combined with W or Nb, or by setting the atomic ratio of Al at 20% or more when Al is combined with Hf. Description is not provided of the suitable atomic ratio of Al when a metal other than Ti, V, Cr, W, Nb, Hf and the like mentioned above is used. However, even when a metal other than the above-mentioned metals is used, the effects of the present invention are estimated to be obtained as long as the atomic ratio of Al is adjusted such that the coating layer includes the hexagonal crystal. When the coating layer includes Si, an atomic ratio of Si to a metal element included in the coating layer is preferably 10% or less.

Preferably, the above-mentioned coating layer is formed of 10 or more layers, and more preferably is formed of 100 or more layers. Since a plurality of layers are stacked as mentioned above, an interface between the layers serves as resistance for heat transmission and the thermal permeability can be decreased. As the number of stacked layers increases, the number of interfaces increases and the thermal permeability decreases, and thus, it becomes easy to satisfy the thermal permeability of 8000 J/s^{0.5}•m²•K or less.

In addition, at least a part of the coating layer preferably includes an ultra-multilayer structure. The ultra-multilayer structure herein refers to a structure formed by stacking approximately 100 to 10000 layers, where there are two or more kinds of layers having different properties and compositions, with a thickness of several nanometers to several hundred nanometers (normally, they are alternately stacked in the vertical direction). In this case, the film forming speed is excellent because a plurality of different targets are simultaneously used for coating. In addition, the film properties of the coating layer such as hardness, heat insulation property and oxidation resistance are enhanced because the layers having different properties and compositions are combined. Therefore, the above-mentioned structure is preferable.

In addition, in the present invention, at least one layer of coating layer 3 must be formed to achieve high adhesiveness to base material 2, and thus, at least one layer of coating layer 3 is preferably formed by a film forming process that allows high adhesiveness to base material 2. Any conventionally known film forming processes can be used as the above-mentioned film forming process. For example, a PVD (physical vapor deposition) method, a CVD (chemical vapor deposition) method and the like can be used, and two or more conventionally known film forming processes may be combined.

Among these film forming processes, the use of the PVD method is particularly preferable because the coating layer is not easily cracked after coating layer 3 is formed, and the oxidation resistance can be enhanced. In the PVD method, coating layer 3 can be formed at a low temperature and coating layer 3 can be formed while creating distortion in coating layer 3, as compared with the CVD method. Therefore, crystal grains tend to become fine, and the coating layer having a low thermal permeability can be formed. In addition, in the PVD method, compressive stress can be given to coating layer 3, and chipping that easily occurs in the coating layer during use of the tool is easily suppressed.

The conventionally known PVD method can be used without particular limitation as the PVD method suitably used in the present invention. The above-mentioned PVD method can include, for example, a sputtering method, an arc ion plating method, a vapor deposition method and the like. Particularly, the arc ion plating method or the magnetron sputtering method is preferably employed.

The coating layer in the present invention preferably has a thickness of 5 µm or more and 50 µm or less. Since the coating layer has a thickness of 5 µm or more as mentioned above, the wear resistance can be enhanced and the tool life can be significantly lengthened. More preferably, the coating layer in the present invention has a thickness of 10 µm or more and 30 µm or less, and further preferably 10 µm or more and 20 µm or less. As a result, the tool life can be further lengthened and excellent chipping resistance can also be achieved.

In the present invention, the thickness of the coating layer refers to the thickness of the coating layer at any portion of the surface of the tool for friction stir welding, and refers to, for example, the thickness of the coating layer at a tip of the probe portion, of the thickness of the coating layer formed on the base material of the tool for friction stir welding.

Although the coating layer in the present invention is preferably formed to coat the entire surface of the base material, even a coating layer that does not coat a part of the base material, or a coating layer having a different configuration at any portion on the base material does not depart from the scope of the present invention. The coating layer in the present invention is preferably formed at least on all or a part of the chuck portion on the base material as mentioned above, and is more preferably formed at least on the portion that comes into contact with the materials to be joined during joining processing.

The coating layer in the present invention is characterized by having compressive stress. Since the coating layer has compressive stress as mentioned above, the chipping resistance of the coating layer can be enhanced. The presence or absence of compressive stress in the coating layer can be determined in accordance with a sin₂φ method using an X-ray stress measuring device.

### <Method for Forming Coating Layer>

As mentioned above, at least one layer of the coating layer in the present invention is preferably formed by the physical vapor deposition (PVD) method. At least one layer of the coating layer in the present invention can also be formed by any PVD methods as long as the PVD method is used, and the type of the forming method is not particularly limited.

When a small substrate bias voltage is applied to base material 2, the elements constituting coating layer 3 are supplied in an ionic state to the base material at low energy. Therefore, an impact when the elements collide with the base material becomes small and the crystallinity of the formed coating layer decreases. As a result, the thermal permeability of formed coating layer 3 can be reduced.

By controlling the substrate bias voltage, the base material temperature and ON/OFF of a heater when the surface region of coating layer 3 is formed, and configuring coating layer 3 such that coating layer 3 has a hexagonal or amorphous structure, the thermal permeability of at least one layer of the coating layer can be reduced.

Bombard processing prior to formation of coating layer 3 is an important step for improving consistency between crystal grains included in coating layer 3 and crystal grains of WC included in the base material, in an interface region between base material 2 and coating layer 3. Specifically, after an argon gas is introduced, the substrate bias voltage is maintained at -1500 V, and the surface of the cemented carbide base material is subjected to the bombard processing while releasing thermal electrons in a W filament, and thereafter, coating layer 3 is formed. As a result, in the interface region between base material 2 and coating layer 3, the crystal grains included in coating layer 3 and the crystal grains of WC included in the base material can have consistency.

The reason for the above is considered as follows. Contamination and an oxide layer on the surface of the crystal grains of WC in the interface region can be removed by the bombard processing, and the degree of activity on the surface of the crystal grains of WC increases. As a result, the crystal grains in the coating layer grow in a manner consistent with the crystal grains of WC. Since the consistency between the crystal grains included in the coating layer and the crystal grains of WC included in the base material is improved as mentioned above, the bonding force between the coating layer and the crystal grains of WC (i.e., base material) is strengthened and excellent peeling resistance can be achieved. When nitride or carbonitride is present in the base material, particularly excellent peeling resistance is achieved.

### Example

While the present invention will be described in more detail hereinafter with reference to Examples, the present invention is not limited thereto. It is to be noted that the thickness of the coating layer in Examples is measured by directly observing a cross section of the coating layer by means of a scanning electron microscope (SEM) or a transmission electron microscope (TEM).

Although the coating layer is formed by a cathode arc ion plating method in the following description, the coating layer may also be formed by, for example, a balanced or unbalanced sputtering method.

### <Example 1>

In the present example, the tool for friction stir welding shown in Fig. 1 is fabricated. The tool for friction stir welding in the present example has cylindrical portion 5 having a substantially cylindrical shape whose diameter is 10 mm and whose height is 20 mm, and probe portion 4 protruding concentrically with cylindrical portion 5 at a central portion of the tip of cylindrical portion 5. Probe portion 4 has a substantially cylindrical shape whose diameter is 4 mm and whose height is 0.7 mm.

### <Fabrication of Tool for Friction Stir Welding>

First, a base material having the above-mentioned tool shape and made of a material shown in Table 1 below is prepared as the base material of the tool for friction stir welding. This base material is made of cemented carbide and includes WC crystal grains, and the average particle size of each of these crystal grains (in the surface of the base material (interface portion with the coating layer)) is as shown in Table 1.

**[Table 1]**

| | | evaluation of wear resistance |
|---|---|---|
| base material | material of base material | WC-6 wt% Co-10 wt% TiCN-1 wt% TaC-0.5 wt% Cr₃C₂ |
| | average particle size of WC crystal grains | 1 µm |
| material to be joined | material | 980 MPa-grade ultrahigh-tensile steel |
| | plate thickness (mm) | 7 |
| joining condition | number of rotations (r.p.m) | 1500 |
| | indentation depth (mm) | 2 |
| | indentation load (ton) | 0.7 |
| | processing time (sec) | 3 |

Subsequently, the pressure within a chamber of the apparatus is lowered by means of a vacuum pump, and the base material is heated to 450°C by means of a heater placed in the apparatus. The chamber is evacuated until the pressure within the chamber reaches 1.0× 10⁻⁴ Pa.

Next, an argon gas is introduced and the pressure within the chamber is maintained at 3.0 Pa. The voltage of a substrate bias power supply of the base material is gradually raised to -1500 V, and cleaning of the surface of the base material is performed for 15 minutes while heating a W filament and releasing thermal electrons. Thereafter, the argon gas is discharged.

The tool for friction stir welding in this Example has probe portion 4 and shoulder portion 6 as shown in Fig. 2, and has chuck portion 7 such that cylindrical portion 5 is inserted into the holder. This chuck portion 7 is formed by cutting away the side surface of cylindrical portion 5 by a length of 10 mm from an upper surface of cylindrical portion 5, from opposing two directions, and has a substantially cylindrical cross-sectional shape. When chuck portion 7 is viewed from the holder side, the length of a chord formed by cutting as mentioned above is 7 mm.

Then, the coating layer is formed on the probe portion and shoulder portion 6 to be in direct contact with the base material, and thereby the tool for friction stir welding in Example 1 is fabricated. Specifically, a preset target of alloy (Ti_{0.5}Al_{0.5} and Al_{0.75}Ti_{0.25}) serving as a metal evaporation source is used, a nitrogen gas serving as a reaction gas is introduced, the reaction gas pressure is set to 4.0 Pa, and the substrate bias voltage and the base material temperature are varied. In this manner, an arc current of 100 A is supplied to a cathode electrode and metal ions are generated from an arc-type evaporation source. Thus, the coating layer formed of a Ti_{0.5}Al_{0.5}N layer having a thickness of 6 µm and a Al_{0.75}Ti_{0.25}N layer having a thickness of 6 µm is formed on the probe portion and shoulder portion 6.

### <Examples 2 to 7 and 9>

In each of Examples 2 to 7 and 9, a tool for friction stir welding is fabricated using a method similar to that in Example 1 except that the configuration and composition of the coating layer are different from those in Example I as shown in Table 2 below. For example, in Example 3, 120 layers of a Ti_{0.5}Al_{0.5}N layer having a thickness of 0.05 µm and 120 layers of a Al₀.₇₅Ti_{0.25}N layer having a thickness of 0.05 µm are alternately stacked on the base material, and thereby the coating layer formed of 240 layers in total is formed. When two types of compositions are listed in the section "composition" of coating layer in Table 2, it means that a layer having a composition shown on the left side is formed, and thereafter, a layer having a composition shown on the right side is formed directly on the layer.

**[Table 2]**

| | coating layer | | | | | | |
|---|---|---|---|---|---|---|---|
| | composition and structure (* A number in the parenthesis beside a composition refers to a thickness (µm) of a layer having the composition.) | number of layers | layer thickness (µm) | crystal system | thermal permeability J/s^{0.5}•m²•K) | compressive stress | portion of formation |
| Example 1 | Ti_{0.5}Al_{0.5}N(6)/Al_{0.75}Ti_{0.25}N(6) | 2 | 12 | hexagonal crystal layer and cubic crystal layer | 5500 | present | probe portion and shoulder portion |
| Example 2 | alternately stacked layers of Ti_{0.5}Al_{0.5}N(1)/Al_{0.75}Ti_{0.25}N(1) | 12 | 12 | hexagonal crystal layer and cubic crystal layer | 4800 | present | probe portion and shoulder portion |
| Example 3 | alternately stacked layers of Ti_{0.5}Al_{0.5}N(0.05)/Al_{0.75}Ti_{0.25}N(0.05) | 240 | 12 | hexagonal crystal layer and cubic crystal layer | 4500 | present | probe portion and shoulder portion |
| Example 4 | alternately stacked layers of Ti_{0.5}Al_{0.5}N(0.01)/Al_{0.75} Ti_{0.5}N(0.01) | 1200 | 12 | hexagonal crystal layer and cubic crystal layer | 4000 | present | probe portion and shoulder portion |
| Example 5 | Al_{0.8}Cr_{0.2}N(6)/Al_{0.6}Cr_{0.4}N(6) | 2 | 12 | hexagonal crystal layer and cubic crystal layer | 4500 | present | probe portion and shoulder portion |
| Example 6 | Ti_{0.5}Al_{0.5}N(4)/Al_{0.7}Cr_{0.3} N(7)/alumina(1) | 3 | 12 | cubic crystal layer and amorphous layer | 4000 | present | probe portion and shoulder portion |
| Example 7 | Al_{0.75}Cr_{0.25}N(10)/Al_{0.8}Cr_{0.2}ON(2) | 2 | 12 | hexagonal crystal layer and cubic crystal layer | 3500 | present | probe portion and shoulder portion |
| Example 8 | alternately stacked layers of Ti_{0.5}Al_{0.5}N(0.05)/Al_{0.25}Ti_{0.25}N(0.05) | 240 | 12 | hexagonal crystal layer and cubic crystal layer | 4500 | present | probe portion, shoulder portion and chuck portion |
| Example 9 | Ti_{0.6}Al_{0.4}N(10)/Al_{0.7}V_{0.25}Si_{0.05}N(2) | 2 | 12 | hexagonal crystal layer and cubic crystal layer | 7800 | present | probe portion and shoulder portion |
| Comparative Example 1 | Al_{0.75}Ti_{0.25}N(5) | 1 | 5 | hexagonal crystal layer | 4000 | present | probe portion and shoulder portion |
| Comparative Example 2 | TiN(1)/TiCN(8)/alumina(3) | 3 | 12 | hexagonal crystal layer and cubic crystal layer | 12000 | not present | probe portion and shoulder portion |
| Comparative Example 3 | Al₀.₇Cr₀.₃N(12) | 1 | 12 | cubic crystal layer | 5500 | present | probe portion and shoulder portion |
| Comparative Example 4 | Ti_{0.5}Al_{0.5}N(6)/Al_{0.6}Ti_{0.4}N(6) | 2 | 12 | cubic crystal layer | 6200 | present | probe portion and shoulder portion |
| Comparative Example 5 | Ti_{0.8}Si_{0.2}N(5) | 1 | 5 | cubic crystal layer and amorphous layer | 8200 | present | probe portion and shoulder portion |

### <Example 8>

In Example 8, a tool for friction stir welding is fabricated similarly to Example 3 except that the coating layer is formed not only on the probe portion and the shoulder portion but also on the chuck portion.

### <Comparative Examples 1 to 5>

A tool for friction stir welding in each of Comparative Examples 1 and 3 to 5 is fabricated using a method similar to that in Example 1 except that the coating layer is different in composition from the coating layer in Example 1 as shown in Table 2. A tool for friction stir welding in Comparative Example 2 is fabricated by forming the coating layer having a composition shown in Table 2 on the base material shown in Table 1 by using the known CVD method.

The thermal permeability of the entire coating layer of the tool for friction stir welding in each of Examples 1 to 9 and Comparative Examples 1 to 5 fabricated as mentioned above is measured by means of the thermophysical properties microscope (product name: Thermal Microscope TM3 (BETHEL Co.)) in accordance with the thermoreflectance method, and the result is shown in the section "thermal permeability" in Table 2. In addition, the residual compressive stress in the coating layer is measured in accordance with the sin²φ method using the X-ray stress measuring device. When it is determined that the compressive stress is present, "present" is shown in the section "compressive stress" in Table 2. When it is determined that the compressive stress is not present, "not present" is shown in the section "compressive stress" in Table 2.

In addition, the crystal structure of the coating layer of the tool for friction stir welding in each Example and each Comparative Example is checked by XRD (X-ray diffraction) or electron diffraction using the TEM. When it is determined that the coating layer includes a layer including a cubic crystal, "cubic crystal layer" is shown in the section "crystal system" in Table 2. When it is determined that the coating layer includes a layer including a hexagonal crystal, "hexagonal crystal layer" is shown in the section "crystal system" in Table 2. When it is determined that the coating layer includes a layer including an amorphous structure, "amorphous layer" is shown in the section "crystal system" in Table 2.

### <Evaluation of Tool for Friction Stir Welding>

Friction spot joining (spot FSW) is performed under the conditions shown in Table 1 above, and the penetration speed into the materials to be joined, the wear resistance and the welding resistance are evaluated for each of the tools for friction stir welding in Examples 1 to 9 and Comparative Examples 1 to 5 fabricated in the above. This evaluation is made based on four-stage evaluation criteria of A to D or three-stage evaluation criteria of A to C. The result is shown in Table 3. "A" means that the tool for friction stir welding exhibits the most excellent performance.

### (Penetration Speed)

Based on the number of spots from when the probe portion comes into contact with the materials to be joined to when the shoulder portion comes into contact with the materials to be joined, the penetration speed is evaluated under the following evaluation criteria. The number of spots herein refers to the number of joining points.
A: with 1 spot, the shoulder portion comes into contact with the materials to be joined
B: with 2 spots or more and 5 spots or less, the shoulder portion comes into contact with the materials to be joined
C: with 6 spots or more and 10 spots or less, the shoulder portion comes into contact with the materials to be joined
D: with 11 spots or more, the shoulder portion comes into contact with the materials to be joined

### (Wear Resistance)

After 1000 spots of friction spot joining (spot FSW), the diameter of the probe portion is measured, and based on an amount of decrease in diameter (mm), the wear resistance is evaluated under the following evaluation criteria.
A: the amount of decrease in wear is less than 0.05 mm
B: the amount of decrease in wear is 0.05 mm or more and 0.1 mm or less
C: the amount of decrease in wear is 0.1 mm or more

### (Welding Resistance)

Based on whether the materials to be joined are welded to the probe portion or not at the time of joining processing of the materials to be joined, the welding resistance is evaluated under the following evaluation criteria.
A: no welding
B: little welding
C: a little welding
D: a lot of welding

**[Table 3]**

| No. | penetration speed | amount of wear | amount of welding |
|---|---|---|---|
| Example 1 | B | A | B |
| Example 2 | B | A | B |
| Example 3 | B | A | B |
| Example 4 | A | A | B |
| Example 5 | B | A | B |
| Example 6 | B | B | A |
| Example 7 | B | B | A |
| Example 8 | A | A | B |
| Example 9 | B | B | B |
| Comparative Example 1 | B | D | B |
| Comparative Example 2 | D | C | C |
| Comparative Example 3 | B | B | D |
| Comparative Example 4 | B | B | D |
| Comparative Example 5 | C | D | D |

As is clear from Table 3, the balance among the joining speed, the wear resistance and the welding resistance is more excellent in the tool for friction stir welding in each of Examples 1 to 9 than in the tool for friction stir welding in each of Comparative Examples 1 to 5. A possible reason for high joining speed in the tool for friction stir welding in each of Examples 1 to 9 is as follows: by using the tool for friction stir welding in which the coating layer has a thermal permeability of 8000 J/s^{0.5}•m²•K or less, the generated frictional heat is effectively used.

In addition, a possible reason for enhanced wear resistance is that the coating layer has the layer including the cubic crystal system. A possible reason for enhanced welding resistance is that the coating layer includes the hexagonal crystal system and/or the amorphous structure. Furthermore, the presence of compressive stress in the coating layer is considered to result in enhancement of the chipping resistance.

Based on the above results, it can be confirmed that the life of the tool for friction stir welding according to the present invention in each of Examples 1 to 9 is expected to be longer than that of the tool for friction stir welding in each of Comparative Examples 1 to 5, and the joining efficiency of the former is higher than that of the latter.

It is recognized that the penetration speed of the tool for friction stir welding in Example 8 is higher than that of the tool for friction stir welding in Example 3. A possible reason for this is as follows: since the coating layer is formed on the chuck portion as well in the tool for friction stir welding in Example 8, heat of the tool for friction stir welding whose temperature has risen due to conduction of the frictional heat is confined within the base material without escaping to the holder with which the tool for friction stir welding is in contact, and the generated frictional heat is effectively conducted to the materials to be joined, which promotes softening of the materials to be joined.

While the embodiments and examples of the present invention have been described above, it is also originally intended to combine configurations of the above-mentioned embodiments and examples as appropriate.

It should be understood that the embodiments and examples disclosed herein are illustrative and not limitative in any respect. The scope of the present invention is defined by the terms of the claims, rather than the description above, and is intended to include any modifications within the scope and meaning equivalent to the terms of the claims.

### REFERENCE SIGNS LIST

1 tool for friction stir welding; 2 base material; 3 coating layer; 4 probe portion; 5 cylindrical portion; 6 shoulder portion; 7 chuck portion.

## Claims

1. A tool (1) for friction stir welding comprising a base material (2) and a coating layer (3) formed on the base material (2), wherein
said coating layer (3) is formed of two or more layers, and said coating layer (3) as a whole has a thermal permeability of 8000 J/s^{0.5}•m²•K or less,
at least one layer of said coating layer (3) includes a hexagonal crystal system and/or an amorphous structure,
at least one layer of said coating layer (3) includes a cubic crystal system, and
said coating layer (3) has compressive stress.

2. The tool (1) for friction stir welding according to claim 1, wherein
said coating layer (3) is formed of 10 or more layers.

3. The tool (1) for friction stir welding according to claim 1 or 2, wherein
said coating layer (3) is formed of 100 or more layers.

4. The tool (1) for friction stir welding according to any one of claims 1 to 3, wherein
said coating layer (3) has a thickness of 10 µm or more.

5. The tool (1) for friction stir welding according to any one of claims 1 to 4, wherein
said tool (1) for friction stir welding has a chuck portion (7) inserted into a holder, and
said coating layer (3) is formed at least on said chuck portion (7) on said base material (2).

6. The tool (1) for friction stir welding according to any one of claims 1 to 5, wherein
said coating layer (3) is formed at least on a portion of said base material (2) that comes into contact with materials to be joined during joining processing.

7. The tool (1) for friction stir welding according to any one of claims 1 to 6, wherein
at least one layer of said coating layer (3) is formed by a physical vapor deposition method.

8. A method for joining materials to be joined using the tool (1) for friction stir welding as recited in any one of claims 1 to 7, wherein
said joining is performed on the materials to be joined having a melting point of 1000°C or higher.

## Patentansprüche

1. Werkzeug (1) zum Reibrührschweißen umfassend ein Basismaterial (2) und eine Beschichtungsschicht (3), die auf dem Basismaterial (2) gebildet ist, wobei
die Beschichtungsschicht (3) aus zwei oder mehr Schichten gebildet ist, und die Beschichtungsschicht (3) als Ganzes eine Wärmedurchlässigkeit von 8000 J/s^{0.5}•m²•K oder weniger aufweist,
wenigstens eine Schicht der Beschichtungsschicht (3) ein hexagonales Kristallsystem und/oder eine amorphe Struktur umfasst,
wenigstens eine Schicht der Beschichtungsschicht (3) ein kubisches Kristallsystem umfasst, und
die Beschichtungsschicht (3) eine Druckspannung aufweist.

2. Werkzeug (1) zum Reibrührschweißen nach Anspruch 1, wobei die Beschichtungsschicht (3) aus 10 oder mehr Schichten gebildet ist.

3. Werkzeug (1) zum Reibrührschweißen nach Anspruch 1 oder 2, wobei die Beschichtungsschicht (3) aus 100 oder mehr Schichten gebildet ist.

4. Werkzeug (1) zum Reibrührschweißen nach einem der Ansprüche 1 bis 3, wobei die Beschichtungsschicht (3) eine Dicke von 10 µm oder mehr aufweist.

5. Werkzeug (1) zum Reibrührschweißen nach einem der Ansprüche 1 bis 4, wobei das Werkzeug (1) zum Reibrührschweißen einen Spannvorrichtungsabschnitt (7) aufweist, der in einen Halter eingesetzt ist, und die Beschichtungsschicht (3) wenigstens auf dem Spannvorrichtungsabschnitt (7) auf dem Basismaterial (2) gebildet ist.

6. Werkzeug (1) zum Reibrührschweißen nach einem der Ansprüche 1 bis 5, wobei die Beschichtungsschicht (3) wenigstens auf einem Teil des Basismaterials (2) gebildet ist, das während des Verbindungsvorgangs mit zu verbindenden Materialien in Kontakt gebracht wird.

7. Werkzeug (1) zum Reibrührschweißen nach einem der Ansprüche 1 bis 6, wobei wenigstens eine Schicht der Beschichtungsschicht (3) durch ein physikalisches Dampfabscheidungsverfahren gebildet wird.

8. Verfahren zum Verbinden von Materialien, die mit dem Werkzeug (1) zum Reibrührschweißen nach einem der Ansprüche 1 bis 7 verbunden werden, wobei das Verbinden an den zu verbindenden Materialien durchgeführt wird, die einen Schmelzpunkt von 1000°C oder höher aufweisen.

## Revendications

1. Un outil (1) pour soudage par friction malaxage comprenant un matériau de base (2) et une couche de revêtement (3) formée sur le matériau de base (2), dans lequel
ladite couche de revêtement (3) est formée de deux ou plusieurs couches, et ladite couche de revêtement (3) a dans son ensemble une perméabilité thermique de 8000 J/s^{0.5}•m²•K ou moins,
au moins une couche de ladite de couche de revêtement (3) comporte un système cristallin hexagonal et/ou une structure amorphe,
au moins une couche de ladite de couche de revêtement (3) comporte un système cristallin cubique, et ladite couche de revêtement (3) est contrainte en compression.

2. L'outil (1) pour soudage par friction malaxage selon la revendication 1, dans lequel ladite couche de revêtement (3) est formée de 10 couches ou plus.

3. L'outil (1) pour soudage par friction malaxage selon la revendication 1 ou 2, dans lequel ladite couche de revêtement (3) est formée de 100 couches ou plus.

4. L'outil (1) pour soudage par friction malaxage selon l'une quelconque des revendications 1 à 3, dans lequel
ladite couche de revêtement (3) a une épaisseur de 10 µm ou plus.

5. L'outil (1) pour soudage par friction malaxage selon l'une quelconque des revendications 1 à 4, dans lequel
ledit outil (1) pour soudage par friction malaxage comporte une partie de mandrin (7) insérée dans un support, et où
ladite couche de revêtement (3) est formée au moins sur ladite partie de mandrin (7) sur ledit matériau de base (2).

6. L'outil (1) pour soudage par friction malaxage selon l'une quelconque des revendications 1 à 5, dans lequel
ladite couche de revêtement (3) est formée au moins sur une partie dudit matériau de base (2) qui entre en contact avec des matériaux à lier pendant le processus de soudage.

7. L'outil (1) pour soudage par friction malaxage selon une des revendications 1 à 6, où
au moins une couche de ladite couche de revêtement (3) est formée par une méthode de dépôt physique en phase vapeur.

8. Une méthode de liaison de matériaux à lier en utilisant l'outil (1) pour soudage par friction malaxage tel que récité dans l'une quelconque des revendications 1 à 7, dans laquelle
ladite liaison est effectuée sur les matériaux à lier ayant un point de fusion de 1000°C ou plus.
